# EUROPEAN PATENT SPECIFICATION

(11) **EP 3 407 121 B1**
(45) Date of publication and mention of the grant of the patent: **08.09.2021**
(21) Application number: 17172204.4
(22) Date of filing: 22.05.2017
(51) Int. Cl.: G02F 1/015, B82Y 30/00, H01L 51/00, H01L 31/00, H01L 29/16

(54) **LAMINATED HETEROSTRUCTURE DEVICE, APPARATUS COMPRISING THE SAME, AND METHOD OF OPERATING A LAMINATED HETEROSTRUCTURE DEVICE**
LAMINIERTE HETEROSTRUKTURVORRICHTUNG, EINRICHTUNG DAMIT UND VERFAHREN ZUM BETRIEB EINER LAMINIERTEN HETEROSTRUKTURVORRICHTUNG
DISPOSITIF À STRUCTURE HÉTÉROGÈNE STRATIFIÉE, APPAREIL LE COMPRENANT ET PROCÉDÉ DE FONCTIONNEMENT D'UN DISPOSITIF À STRUCTURE HÉTÉROGÈNE STRATIFIÉE

(43) Date of publication of application: 28.11.2018
(73) Proprietor: Vestel Elektronik Sanayi ve Ticaret A.S., 45030 Manisa (TR); Ozyegin Universitesi, 34794 Istanbul (TR)
(72) Inventor: GÜLBAHAR, Burhan, 34794 Çekmeköy/Istanbul (TR); MEMISOGLU, Gorkem, 45030 Manisa (TR)
(74) Representative: Kehl, Ascherl, Liebhoff & Ettmayr Patentanwälte Partnerschaft mbB

(56) References cited:
- WO-A1-2015/130189
- CN-A- 104 201 287
- US-A1- 2015 083 206
- US-A1- 2015 332 920
- Linder Jacob ET AL: "Dynamical tuning between nearly perfect reflection, absorption, and transmission of light via graphene/dielectric structures", Scientific Reports, vol. 6, no. 1, 1 December 2016 (2016-12-01), XP55781986, DOI: 10.1038/srep38141 Retrieved from the Internet: URL:http://www.nature.com/articles/srep381 41>

## Description

The present invention relates to an apparatus according to claim 1 comprising a plurality of laminated heterostructure devices, and a method according to claim 10 of operating an apparatus comprising a plurality of laminated heterostructure devices.

### Background of the Invention

It is known to use laminated heterostructures of two-dimensional materials, such as graphene, black phosphorus and transition metal dichalcogenides (TMDs), for optical modulation of electromagnetic radiation in the infrared and visible wavebands. Sun, Z., Martinez, A. & Wang, F. (2016): "Optical Modulators with Two-dimensional Layered Materials", Nature Photonics, 10(4), pp. 227-238, describes optical modulation by layered material heterostructures, in which atomically thin two-dimensional layers, such as of graphene and hexagonal boron nitride (h-BN), are prepared separately and then stacked together to form van der Waals-bonded heterostructures.

US 2015/1568747 describes an optical modulator including a junction formed by at least one layer of graphene which forms an electrode and a transmittance modulation layer and a dielectric layer, wherein an amount of charge accumulated in the graphene is controlled by applying voltage to the junction to control transmitted light intensity. This document also discloses the use of such a junction in an imaging device and in a display apparatus. Examples of dielectric substances for use in the dielectric layer include silicon dioxide (SiO₂) and hexagonal boron nitride (h-BN).

Graphene layers have also been used in energy harvesting. For example, WO 2012/134807 describes a solar cell comprising an n-type semiconductive graphene layer stacked on a p-type semiconductive graphene layer, and CN 104201287 A describes a perovskite-based flexible film solar cell comprising graphene electrodes. US 2015/0083206 describes cells and devices for harvesting light. The cell described therein comprises at least one electrode which comprises graphene or modified graphene and a layer of a transition metal dichalcogenide in a vertical heterostructure. The cell may be part of a light harvesting device.

However, such laminated heterostructure devices are application specific and cannot be employed in a wide range of different contexts. It would therefore be advantageous to provide a laminated heterostructure device having several different modes of operation, which can be used in a wide variety of different contexts.

The document "Dynamical tuning between nearly perfect reflection, absorption, and transmission of light via graphene/dielectric structures", Linder Jacob, Halterman Klaus, Scientific Reports, Vol. 6, Issue 1, published 01-12-2016 discloses dynamical tuning between reflection, absorption, and transmission of light via graphene/ dielectric structures.

### Object of the Invention

It is therefore an object of the invention to provide an apparatus comprising a plurality of laminated heterostructure devices, and a method of operating such an apparatus.

### Description of the Invention

The object of the invention is solved by an apparatus according to claim 1. The apparatus at least comprises a plurality of devices arranged in a cellular pattern on a surface, a control unit electrically connected to each of the plurality of devices, an energy harvester electrically connected to the control unit, and a data modulator electrically connected to the control unit. Each device at least comprises a laminated heterostructure of a graphene layer and a dielectric-metal compound layer. The control unit is able to alter the relative proportions in which each of the devices can reflect and absorb incident radiation and to select a mode of operation of each of the devices from one or more of: transmitting data supplied from the data modulator by optical modulation of incident radiation; harvesting energy from incident radiation and relaying the harvested energy to the energy harvester; and reflecting incident radiation.

The control unit may comprise control electronics, optionally associated with software, and one or more user controls, such as buttons and/or switches. The control unit can alter the relative proportions in which the laminated heterostructure of each device can reflect and absorb incident radiation by tuning the optoelectronic properties of the laminated heterostructure. The terms "optoelectronic" and "optical modulation" as used herein are not restricted to refer just to radiation in the visible waveband, but are also intended to refer to radiation in the infrared part of the electromagnetic spectrum.

This solution is beneficial because such a device can be used to transmit data by optical modulation of incident radiation, to harvest energy from incident radiation and/or to reflect incident radiation at different parts of the visible and infrared wavebands by altering the relative proportions in which the laminated heterostructure can reflect and absorb incident radiation via the control unit. The device can therefore be used in a wide range of different applications, as will become apparent from the description given hereinbelow.

Advantageous embodiments of the invention may be configured according to any claim and/or part of the following description.

In one possible preferred embodiment, the control unit is further configured to set the relative proportions in which the laminated heterostructure can reflect and absorb incident radiation to be different at different wavelengths of the incident radiation. Thus, for example, the laminated heterostructure may be tuned to absorb a majority of the incident radiation in a narrow waveband in the visible part of the electromagnetic spectrum, but to reflect more radiation than it absorbs in other parts of the visible waveband and in the infrared parts of the electromagnetic spectrum. Other examples are also possible.

Preferably, the dielectric-metal compound layer comprises at least one of doped silicon and doped aluminium. However, the dielectric-metal compound layer may in general comprise any semiconducting material or combination of insulating and conducting materials which together with the graphene layer are able to have their optoelectronic properties tuned as desired.

The plurality of devices may be created by inkjet printing or spray-painting graphene onto a surface already prepared with the dielectric-metal compound layer and with appropriate electrical connections to the control unit, to the data modulator and to the energy harvester, and then exposing the surface to infrared radiation strong enough to create the laminated heterostructure. The control unit may comprise control electronics, optionally associated with software, and one or more user controls, such as buttons and/or switches. These user controls may be hardware controls or virtual controls displayed on a touch screen, for example. The data modulator may be networked to receive data remotely. The energy harvester may comprise one or more of an energy storage device, such as an electrical cell or battery or a capacitor, and an energy consuming device, such as a motor, actuator or data processor.

This solution is beneficial because the plurality of devices can be used to cover a surface, such as a wall of a room or an outer surface of a domestic appliance or an electronic device, thereby providing the room or the appliance or device with a versatile coating which can change its optoelectronic properties for data transmission, energy harvesting and reflecting radiation as desired. For example, the data transmission mode of operation may be used to communicate status information from the domestic appliance or electronic device, either by modulation of a data signal in the visible or infrared waveband, or in the form of a visual display. In another example, the energy harvesting mode of operation may be used to supply power to the appliance or device, thereby reducing its overall power consumption. In yet another example, the radiation reflecting mode of operation may be used to provide a room with desired visible and/or thermal properties, which can be switched by means of the control unit, to suit the room to different purposes, such as a darkroom or cinema, or an incubator.

Preferably, the control unit is electrically connected to each of the plurality of devices via separate data and energy transfer cables. The data and energy transfer cables may be laid down in tracks on the surface using conventional electronic production techniques.

Preferably, the surface on which the plurality of similar devices is arranged comprises one of a surface of a building and an outer surface of a domestic appliance or of an electronic device. This solution is beneficial because arranging the devices in a cellular pattern on a surface allows the devices to be addressed in a systematic way and for their optoelectronic properties to be altered by the control unit in a co-ordinated fashion.

In one possible embodiment, the surface may comprise an outer surface of a domestic appliance or of an electronic device, and the control unit is housed within the domestic appliance or electronic device. The domestic appliance may, for example, be any of a washing machine, dishwasher, oven, refrigerator or heating, ventilation and air-conditioning unit. The electronic device may, for example, be a portable electronic device, such as a mobile phone, laptop or tablet computer.

In an alternative possible embodiment, the surface may comprise a wall, ceiling, floor or roof of a building, the control unit is mounted on, in or behind the surface, and the apparatus further comprises a remote controller configured for wireless communication with the control unit. This solution is advantageous because it allows a user to control the operation of the apparatus remotely.

Preferably, the plurality of devices have a similar shape to each other which can be tessellated on the surface. This solution is beneficial because it allows large surfaces to be completely covered with such a plurality of devices quickly and easily.

In one possible preferred embodiment, the plurality of devices may be integrated into a flexible membrane. This solution is beneficial because it allows the apparatus to be applied to surfaces which cannot be treated using an inkjet printing or spray-painting technique, by covering the surface with such a membrane.

The present invention also relates to a method of operating an apparatus comprising a plurality of devices each comprising a laminated heterostructure of a graphene layer and a dielectric-metal compound layer, wherein the method at least comprises arranging the plurality of devices in a cellular pattern on a surface, altering the relative proportions in which the laminated heterostructure of at least one of the devices can reflect and absorb incident radiation, and selecting whether each device transmits data by modulating the reflected radiation, harvests energy from the absorbed radiation, reflects incident radiation, or a combination of all three.

Preferably, the method further comprises setting the relative proportions in which the laminated heterostructure of at least one of the devices can reflect and absorb incident radiation to be different at different wavelengths of the incident radiation. This solution is beneficial because it allows, for example, the optoelectronic properties of the laminated heterostructure to be made different in one part of the electromagnetic spectrum (for example, the visible waveband) from what they are in another part of the electromagnetic spectrum (for example, the infrared).

In one possible preferred embodiment, the laminated heterostructure of at least one of the devices may be tuned to absorb or reflect substantially all of the incident radiation in the visible waveband. If the laminated heterostructure is tuned to absorb substantially all of the incident radiation in the visible waveband, it will appear black. If, on the other hand, the laminated heterostructure is tuned to reflect substantially all of the incident radiation in the visible waveband, it will have a specular (mirror-like) appearance. The former, black appearance is useful, for example, if the laminated heterostructure is applied to the walls of a room to be used for screening a film, in the manner of a cinema, or for carrying out light-sensitive operations, such as developing photographic film. The latter, mirror-like appearance can be useful, for example, in other applications, such as lighting and relaying optical information.

Alternatively or additionally, the laminated heterostructure of at least one of the devices may be tuned to absorb or reflect substantially all of the incident radiation in the infrared waveband. If the laminated heterostructure is tuned to absorb substantially all of the incident radiation in the infrared waveband, this makes the device useful for energy harvesting purposes. If, on the other hand, the laminated heterostructure is tuned to reflect substantially all of the incident radiation in the infrared waveband, this makes the device useful in heating and insulation applications, by preventing the leakage of thermal radiation through a surface on which the laminated heterostructure is applied.

The method may further comprise modulating incident radiation reflected by the laminated heterostructure of at least one of the devices with a data signal. The data can be modulated at frequencies up to several GHz. This solution is therefore beneficial because it allows the laminated heterostructure to be used to transmit data very rapidly.

The present invention further relates to a computer program product or a program code or system for executing one or more than one of the herein described methods.

Further features, goals and advantages of the present invention will now be described in association with the accompanying drawings, in which exemplary components of the invention are illustrated. Components of the devices and methods according to the invention which are at least essentially equivalent to each other with respect to their function can be marked by the same reference numerals, wherein such components do not have to be marked or described in all of the drawings.

In the following description, the invention is described by way of example only with respect to the accompanying drawings.

### Brief Description of the Drawings

Fig. 1 is a schematic diagram of a device comprising a laminated heterostructure; and
Fig. 2 is a schematic diagram of an embodiment of an apparatus comprising a cellular membrane of the laminated heterostructure of Fig. 1 applied to a surface.

### Detailed Description

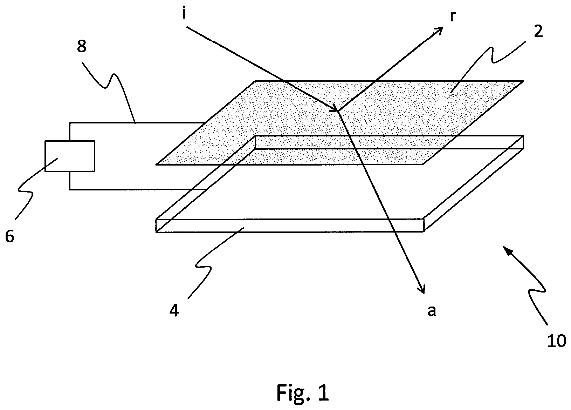

Fig. 1 schematically shows a device comprising a laminated heterostructure 10. The laminated heterostructure 10 comprises a graphene layer 2 and a dielectric-metal compound layer 4. The dielectric-metal compound layer 4 may, for example, comprise doped silicon or doped aluminium. In Fig. 1, the graphene layer 2 and the dielectric-metal compound layer 4 have been shown separately from each other for the purposes of improved clarity of illustration. However, in practice, the graphene layer 2 and the dielectric-metal compound layer 4 are laminated together, and are therefore actually in contact with each other. Incident radiation, i, falling on the laminated heterostructure 10 is converted into reflected radiation, r, and absorbed radiation, a, in different relative proportions, such that the amount of reflected radiation, r, plus the amount of absorbed radiation, a, adds up to the total amount of incident radiation, i. The relative proportions of the reflected radiation, r, and of the absorbed radiation, a, are variable and depend on the optoelectronic properties of the laminated heterostructure 10, which are tuneable.

To this end, the device of Fig. 1 further comprises a data modulating and energy harvesting control unit 6, which is electrically connected to the laminated heterostructure 10 via circuitry 8. The control unit 6 is configured to alter the relative proportions in which the laminated heterostructure 10 reflects and absorbs incident radiation. The control unit 6 may set the relative proportions in which the laminated heterostructure 10 can reflect and absorb incident radiation to be different at different wavelengths of the incident radiation. The control unit 6 is also configured to select whether the laminated heterostructure 10 transmits data by optical modulation of incident radiation, harvests energy from incident radiation, reflects incident radiation, or a combination of all three. The reflected radiation, r, can be used to transmit data by modulating a data signal supplied to the laminated heterostructure 10 by the control unit 6, whereas the absorbed radiation, a, can be harvested as energy by the control unit 6.

During operation, the control unit 6 alters the relative proportions in which the laminated heterostructure 10 reflects and absorbs incident radiation as desired. For example, the control unit 6 may alter the optoelectronic properties of the laminated heterostructure 10 to have four different modes of operation: a first mode, in which the laminated heterostructure 10 reflects visible light, a second mode, in which the laminated heterostructure 10 appears dark, a third mode, in which the laminated heterostructure 10 transmits data by optical modulation of incident radiation, and a fourth mode, in which the laminated heterostructure 10 reflects infrared radiation, for heating and insulation. The control unit then selects one of these different modes of operation.

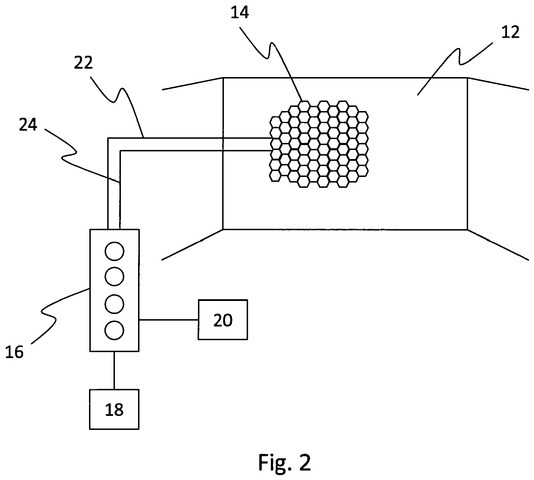

Fig. 2 schematically shows an embodiment of an apparatus comprising a plurality of devices 14, each of which comprises a laminated heterostructure 10 comprising a graphene layer 2 and a dielectric-metal compound layer 4. The devices 14 are similar to each other and can be arranged in a cellular pattern on a surface. In the embodiment shown in Fig. 2, the devices 14 are each hexagonal in shape, so that they can be tessellated, and are integrated into a flexible membrane, which has been applied to a surface 12, such as to a wall of a building or an outer surface of a domestic appliance or electronic device. Whereas in the illustrated embodiment, each of the devices 14 is shown as macroscopic, in other embodiments, they may instead be microscopic or even nanoscale devices.

The apparatus of Fig. 2 further comprises a control unit 16, an energy harvester 18 and a data modulator 20. The control unit 16 is electrically connected to each of the plurality of devices 14 via a data cable 22 and an energy transfer cable 24. The energy harvester 18 is electrically connected to the control unit 16 to collect energy harvested by the devices 14, and the data modulator 20 is electrically connected to the control unit 16 to supply the devices 14 with a data signal which the devices 14 can modulate to transmit data. The control unit 16 is able to select a mode of operation of each of the devices 14 to do one or more of: transmit data supplied from the data modulator 20 using optical modulation of reflected radiation incident on the respective devices 14, harvest energy from radiation absorbed by the respective devices 14 and relay the harvested energy to the energy harvester 18, and reflect the radiation incident on the respective devices 14.

During operation, one or more of the devices 14 may be in a different mode of operation than other ones of the devices 14. For example, most of the devices may be in a "dark" mode to provide the surface 12 with an overall visual appearance of blackness, but a small minority of the devices 14 may be in a data transmission mode to transmit a data signal or to provide a visual display. Thus the apparatus can simultaneously display information and provide a dark environment in which the information is displayed.

In summary, therefore, the present invention provides an apparatus at least comprising a plurality of devices arranged in a cellular pattern on a surface, wherein each device comprises a laminated heterostructure of a graphene layer and a dielectric-metal compound layer. The dielectric-metal compound layer may, for example, comprise doped silicon or doped aluminium. The apparatus also comprises a control unit electrically connected to each of the plurality of devices, an energy harvester electrically connected to the control unit, and a data modulator electrically connected to the control unit. The control unit is configured to alter the relative proportions in which the laminated heterostructure of each device can reflect and absorb incident radiation by altering the optoelectronic properties of the laminated heterostructure, and to select whether the laminated heterostructure transmits data by optical modulation of incident radiation, harvests energy from incident radiation, reflects incident radiation, or a combination of all three. Thus the invention also provides a method of operating such an apparatus. The control unit may set the relative proportions in which the laminated heterostructure can reflect and absorb incident radiation to be different at different wavelengths, and to absorb or reflect substantially all of the incident radiation in a particular waveband. The plurality of devicesmay be arranged in a cellular pattern on a surface, for example by inkjet printing or by being integrated into a flexible membrane. The surface may, for example, be a wall of a building or an outer surface of a domestic appliance or of an electronic device. Thus the apparatus is able to provide the surface of whatever object it is applied to with a "smart" coating, the optoelectronic properties of which can be altered as desired to give the surface a variety of different functions.

### Reference Numerals:

- 2: Graphene layer
- 4: Dielectric-metal compound layer
- 6: Data modulator/energy harvester
- 8: Interconnecting circuitry
- 10: Laminated heterostructure
- a: Absorbed radiation
- i: Incident radiation
- r: Reflected radiation
- 12: Surface
- 14: Cellular membrane of laminated heterostructure devices
- 16: Control unit
- 18: Energy harvester
- 20: Data modulator
- 22: Data cable
- 24: Energy transfer cable

## Claims

1. An apparatus at least comprising:
a plurality of devices (14) arranged in a cellular pattern on a surface (12), wherein each device (14) at least comprises a laminated heterostructure (10) of a graphene layer (2) and a dielectric-metal compound layer (4);
a control unit (16) electrically connected to each of the plurality of devices (14);
an energy harvester (18) electrically connected to the control unit (16); and
a data modulator (20) electrically connected to the control unit (16);
wherein the control unit (16) is able to alter the relative proportions in which each of the devices (14) can reflect and absorb incident radiation and to select a mode of operation of each of the devices (14) from one or more of:
transmitting data supplied from the data modulator (20) by optical modulation of incident radiation;
harvesting energy from incident radiation and relaying the harvested energy to the energy harvester (18); and
reflecting incident radiation.

2. An apparatus according to claim 1, wherein the control unit (16) is further configured to set the relative proportions in which the laminated heterostructure (10) of each device can reflect and absorb incident radiation to be different at different wavelengths of the incident radiation.

3. An apparatus according to claim 1 or claim 2, wherein the dielectric-metal compound layer (4) comprises at least one of doped silicon and doped aluminium.

4. An apparatus according to any one of the preceding claims, wherein the control unit (16) is electrically connected to each of the plurality of devices (14) via separate data (22) and energy transfer (24) cables.

5. An apparatus according to any one of the preceding claims, wherein the surface (12) comprises one of a surface of a building and an outer surface of a domestic appliance or of an electronic device.

6. An apparatus according to claim 5, wherein the surface (12) comprises an outer surface of a domestic appliance or of an electronic device, and the control unit (16) is housed within the domestic appliance or electronic device.

7. An apparatus according to claim 5, wherein the surface (12) comprises a wall, ceiling, floor or roof of a building, the control unit (16) is mounted on, in or behind the surface, and the apparatus further comprises a remote controller configured for wireless communication with the control unit (16).

8. An apparatus according to any one of the preceding claims, wherein the plurality of devices (14) have a similar shape to each other which can be tessellated on the surface (12).

9. An apparatus according to any one of the preceding claims, wherein the plurality of devices (14) are integrated into a flexible membrane.

10. A method of operating an apparatus comprising a plurality of devices (14) each comprising a laminated heterostructure (10) of a graphene layer (2) and a dielectric-metal compound layer (4), the method at least comprising:
arranging the plurality of devices (14) in a cellular pattern on a surface (12);
altering the relative proportions in which the laminated heterostructure (10) of at least one of the devices can reflect and absorb incident radiation; and
selecting whether each device transmits data by modulating the reflected radiation, harvests energy from the absorbed radiation, reflects incident radiation, or a combination of all three.

11. A method according to claim 10, further comprising setting the relative proportions in which the laminated heterostructure (10) of at least one of the devices can reflect and absorb incident radiation to be different at different wavelengths of the incident radiation.

12. A method according to claim 10 or claim 11, comprising tuning the laminated heterostructure (10) of at least one of the devices to absorb or reflect substantially all of the incident radiation in the visible waveband.

13. A method according to any one of claims 10 to 12, comprising tuning the laminated heterostructure (10) of at least one of the devices to absorb or reflect substantially all of the incident radiation in the infrared waveband.

14. A method according to any one of claims 10 to 13, comprising modulating incident radiation reflected by the laminated heterostructure (10) of at least one of the devices with a data signal.

## Patentansprüche

1. Eine Vorrichtung, die mindestens aufweist:
eine Vielzahl von Vorrichtungen (14), die in einem zellularen Muster auf einer Oberfläche (12) angeordnet sind, wobei jede Vorrichtung (14) zumindest eine laminierte Heterostruktur (10) aus einer Graphenschicht (2) und einer dielektrisch-metallische Verbindungsschicht (4) aufweist;
eine Steuereinheit (16), die elektrisch mit jeder der Vielzahl von Vorrichtungen (14) verbunden ist;
einen Energiesammler (18), der elektrisch mit der Steuereinheit (16) verbunden ist; und
einen Datenmodulator (20), der elektrisch mit der Steuereinheit (16) verbunden ist;
wobei die Steuereinheit (16) in der Lage ist, die relativen Anteile, in denen jede der Vorrichtungen (14) einfallende Strahlung reflektieren und absorbieren kann, zu ändern und einen Betriebsmodus jeder der Vorrichtungen (14) aus einem oder mehreren der folgenden auszuwählen:
Übertragung von Daten, die vom Datenmodulator (20) durch optische Modulation der einfallenden Strahlung geliefert werden;
Sammeln von Energie aus einfallender Strahlung und Weiterleiten der gesammelten Energie an den Energiesammler (18); und
Reflektieren der einfallenden Strahlung.

2. Vorrichtung gemäß Anspruch 1, wobei die Steuereinheit (16) ferner so konfiguriert ist, dass sie die relativen Proportionen, in denen die laminierte Heterostruktur (10) jeder Vorrichtung einfallende Strahlung reflektieren und absorbieren kann, so einstellt, dass sie bei verschiedenen Wellenlängen der einfallenden Strahlung unterschiedlich sind.

3. Vorrichtung gemäß Anspruch 1 oder Anspruch 2, wobei die dielektrisch-metallische Verbindungsschicht (4) mindestens eines von dotiertem Silizium und dotiertem Aluminium aufweist.

4. Vorrichtung gemäß einem der vorhergehenden Ansprüche, wobei die Steuereinheit (16) mit jeder der mehreren Vorrichtungen (14) über separate Daten- (22) und Energieübertragungskabel (24) elektrisch verbunden ist.

5. Vorrichtung gemäß einem der vorangehenden Ansprüche, wobei die Oberfläche (12) entweder eine Oberfläche eines Gebäudes und eine Außenfläche eines Haushaltsgeräts oder einer elektronischen Vorrichtung aufweist.

6. Vorrichtung gemäß Anspruch 5, wobei die Oberfläche (12) eine Außenfläche eines Haushaltsgeräts oder einer elektronischen Vorrichtung aufweist und die Steuereinheit (16) innerhalb des Haushaltsgeräts oder der elektronischen Vorrichtung untergebracht ist.

7. Vorrichtung gemäß Anspruch 5, wobei die Oberfläche (12) eine Wand, eine Decke, einen Boden oder ein Dach eines Gebäudes aufweist, die Steuereinheit (16) auf, in oder hinter der Oberfläche montiert ist und die Vorrichtung ferner eine Fernsteuerung aufweist, die für eine drahtlose Kommunikation mit der Steuereinheit (16) konfiguriert ist.

8. Vorrichtung gemäß einem der vorhergehenden Ansprüche, wobei die mehreren Vorrichtungen (14) eine ähnliche Form haben, die auf der Oberfläche (12) mosaikartig angeordnet werden kann.

9. Vorrichtung gemäß einem der vorangehenden Ansprüche, wobei die mehreren Vorrichtungen (14) in eine flexible Membran integriert sind.

10. Verfahren zum Betreiben einer Vorrichtung, die eine Vielzahl von Vorrichtungen (14) aufweist, die jeweils eine laminierte Heterostruktur (10) aus einer Graphenschicht (2) und einer dielektrisch-metallische Verbindungsschicht (4) aufweisen, wobei das Verfahren mindestens aufweist
Anordnen der Vielzahl von Vorrichtungen (14) in einem zellularen Muster auf einer Oberfläche (12);
Ändern der relativen Anteile, in denen die laminierte Heterostruktur (10) von mindestens einer der Vorrichtungen einfallende Strahlung reflektieren und absorbieren kann; und
Auswählen, ob jede Vorrichtung Daten durch Modulation der reflektierten Strahlung überträgt, Energie aus der absorbierten Strahlung erntet, einfallende Strahlung reflektiert oder eine Kombination aus allen dreien.

11. Verfahren gemäß Anspruch 10, das ferner aufweist, dass die relativen Anteile, in denen die laminierte Heterostruktur (10) von mindestens einer der Vorrichtungen einfallende Strahlung reflektieren und absorbieren kann, so eingestellt werden, dass sie bei verschiedenen Wellenlängen der einfallenden Strahlung unterschiedlich sind.

12. Verfahren gemäß Anspruch 10 oder Anspruch 11, aufweisend das Abstimmen der laminierten Heterostruktur (10) mindestens einer der Vorrichtungen, um im Wesentlichen die gesamte einfallende Strahlung im sichtbaren Wellenbereich zu absorbieren oder zu reflektieren.

13. Verfahren gemäß einem der Ansprüche 10 bis 12, aufweisend das Abstimmen der laminierten Heterostruktur (10) von mindestens einer der Vorrichtungen, um im Wesentlichen die gesamte einfallende Strahlung im Infrarot-Wellenbereich zu absorbieren oder zu reflektieren.

14. Verfahren gemäß einem der Ansprüche 10 bis 13, aufweisend das Modulieren einfallender Strahlung, die von der laminierten Heterostruktur (10) mindestens einer der Vorrichtungen reflektiert wird, mit einem Datensignal.

## Revendications

1. Appareil comprenant au moins :
une pluralité de dispositifs (14) disposés selon un motif cellulaire sur une surface (12), dans laquelle chaque dispositif (14) comprend au moins une hétérostructure stratifiée (10) d'une couche de graphène (2) et d'une couche de composé diélectrique-métal (4) ;
une unité de commande (16) connectée électriquement à chacun de la pluralité de dispositifs (14) ;
un collecteur d'énergie (18) connecté électriquement à l'unité de commande (16) ; et
un modulateur de données (20) connecté électriquement à l'unité de commande (16) ;
dans lequel l'unité de commande (16) est capable de modifier les proportions relatives dans lesquelles chacun des dispositifs (14) peut réfléchir et absorber un rayonnement incident et de sélectionner un mode de fonctionnement de chacun des dispositifs (14) à partir d'un ou plusieurs des éléments suivants :
la transmission de données fournies par le modulateur de données (20) par modulation optique du rayonnement incident ;
la récolte d'énergie à partir du rayonnement incident et le relais de l'énergie récoltée vers le collecteur d'énergie (18) ; et
réfléchir le rayonnement incident.

2. Appareil selon la revendication 1, dans lequel l'unité de commande (16) est en outre configurée pour régler les proportions relatives dans lesquelles l'hétérostructure stratifiée (10) de chaque dispositif peut réfléchir et absorber le rayonnement incident pour qu'elles soient différentes à différentes longueurs d'onde du rayonnement incident.

3. Appareil selon la revendication 1 ou la revendication 2, dans lequel la couche de composé diélectrique-métal (4) comprend au moins un élément parmi le silicium dopé et l'aluminium dopé.

4. Appareil selon l'une quelconque des revendications précédentes, dans lequel l'unité de commande (16) est connectée électriquement à chacun de la pluralité de dispositifs (14) via des câbles séparés de transfert de données (22) et d'énergie (24).

5. Appareil selon l'une quelconque des revendications précédentes, dans lequel la surface (12) comprend l'une des surfaces d'un bâtiment et une surface extérieure d'un appareil domestique ou d'un dispositif électronique.

6. Appareil selon la revendication 5, dans lequel la surface (12) comprend une surface extérieure d'un appareil domestique ou d'un dispositif électronique, et l'unité de commande (16) est logée dans l'appareil domestique ou le dispositif électronique.

7. Appareil selon la revendication 5, dans lequel la surface (12) comprend un mur, un plafond, un plancher ou un toit d'un bâtiment, l'unité de commande (16) est montée sur, dans ou derrière la surface, et l'appareil comprend en outre une télécommande configurée pour une communication sans fil avec l'unité de commande (16).

8. Appareil selon l'une quelconque des revendications précédentes, dans lequel la pluralité de dispositifs (14) ont une forme similaire les uns aux autres qui peut être mise en mosaïque sur la surface (12).

9. Appareil selon l'une quelconque des revendications précédentes, dans lequel la pluralité de dispositifs (14) sont intégrés dans une membrane flexible.

10. Méthode de fonctionnement d'un appareil comprenant une pluralité de dispositifs (14) comprenant chacun une hétérostructure stratifiée (10) d'une couche de graphène (2) et d'une couche de composé diélectrique-métal (4), la méthode comprenant au moins :
l'agencement de la pluralité de dispositifs (14) dans un motif cellulaire sur une surface (12) ;
modifier les proportions relatives dans lesquelles l'hétérostructure stratifiée (10) d'au moins un des dispositifs peut réfléchir et absorber un rayonnement incident ; et
sélectionner si chaque dispositif transmet des données en modulant le rayonnement réfléchi, récolte l'énergie du rayonnement absorbé, réfléchit le rayonnement incident, ou une combinaison des trois.

11. Méthode selon la revendication 10, comprenant en outre le réglage des proportions relatives dans lesquelles l'hétérostructure stratifiée (10) d'au moins un des dispositifs peut réfléchir et absorber un rayonnement incident pour qu'elles soient différentes à différentes longueurs d'onde du rayonnement incident.

12. Méthode selon la revendication 10 ou la revendication 11, comprenant le réglage de l'hétérostructure stratifiée (10) d'au moins un des dispositifs pour absorber ou réfléchir sensiblement tout le rayonnement incident dans la bande d'ondes visible.

13. Méthode selon l'une quelconque des revendications 10 à 12, comprenant l'accord de l'hétérostructure stratifiée (10) d'au moins un des dispositifs pour absorber ou réfléchir sensiblement la totalité du rayonnement incident dans la bande d'ondes infrarouges.

14. Méthode selon l'une quelconque des revendications 10 à 13, comprenant la modulation du rayonnement incident réfléchi par l'hétérostructure stratifiée (10) d'au moins un des dispositifs avec un signal de données.
